# EUROPEAN PATENT APPLICATION

(11) **EP 4 804 764 A1**
(43) Date of publication of application: **09.09.2026**
(21) Application number: 25182249.0
(22) Date of filing: 12.06.2025
(51) Int. Cl.: H10F 10/165, H10F 71/00

(54) **SOLAR CELL AND PRODUCTION METHOD OF THE SAME**

(30) Priority: 04.03.2025 CN 202510252259
(71) Applicant: Jinko Solar (Haining) Co., Ltd., Haining City, Zhejiang (CN)
(72) Inventor: JIANG, Linxiang, Haining City (CN); ZHANG, Yuanfang, Haining City (CN); WANG, Zhao, Haining City (CN); YANG, Jie, Haining City (CN); ZHENG, Peiting, Haining City (CN); ZHANG, Xinyu, Haining City (CN); YU, Linglin, Haining City (CN); ZONG, Xiaohui, Haining City (CN)
(74) Representative: Balder IP Law, S.L.

(57) **Abstract**

Embodiments of the present disclosure relate to the field of photovoltaic technology, and provide a solar cell and a method for producing the same. The solar cell includes: a substrate including a front surface and a back surface opposite to each other, front electrodes formed on the front surface, at least one doped structure formed on the back surface and having doping ions of a first type, a tunneling layer covering at least portions of the back surface and a surface of the at least one doped structure away from the substrate, a doped conductive layer formed over a surface of the tunneling layer away from the substrate and having doping ions of a second type, and back electrodes formed on a side of the doped conductive layer away from the substrate and in electrical connection with the doped conductive layer. The first type is one of N type and P type, and the second type is the other one of N type and P type.

## Description

### TECHNICAL FIELD

The present disclosure relates to the technical field of photovoltaic technology, and in particular to a solar cell and a method for producing the same.

### BACKGROUND

Photovoltaic power generation refers to the conversion of solar energy into electrical energy utilizing the photovoltaic effect of semiconductors. For example, TOPCON (Tunnel Oxide Passivated Contact) cells are receiving increasing attention for their excellent photoelectric conversion performance.

A TOPCON cell uses a solar cell technology based on the principle of selective charge carriers, i.e. tunnel oxide passivated contact. In a TOPCON solar cell, selective transport of carriers is achieved by forming passivated contact structures on surface(s) of the substrate. The passivated contact structures include a tunneling layer and a doped conductive layer.

### SUMMARY

Embodiments of the present disclosure provide a solar cell and a method for producing the same, which can at least ameliorate the hot-spot effect on solar cells.

Some embodiments of the present disclosure provide a solar cell, including: a substrate including a front surface and a back surface opposite to each other, front electrodes formed on the front surface, at least one doped structure formed on the back surface and having doping ions of a first type, a tunneling layer covering at least portions of the back surface and a surface of the at least one doped structure away from the substrate, a doped conductive layer formed over a surface of the tunneling layer away from the substrate and including doping ions of a second type, and back electrodes formed on a side of the doped conductive layer away from the substrate and in electrical connection with the doped conductive layer. The first type is one of N type and P type, and the second type is the other one of N type and P type.

In some embodiments, the substrate includes doped areas, and the doped areas are in contact with the at least one doped structure and are substantially aligned with the at least one doped structure, respectively.

In some embodiments, the back surface includes periphery areas and central areas surrounded by the periphery areas, and doped areas formed in the periphery areas have junction depths less than junction depths of doped areas formed in the central areas.

In some embodiments, the doped conductive layer covers at least a portion of sidewalls of the at least one doped structure.

In some embodiments, the solar cell includes a plurality of rows of doped structures. Each row of the plurality of rows of doped structures includes a respective plurality of doped structures, and in an arrangement direction of the plurality of rows of doped structures, the plurality of doped structures of a respective row of the plurality of rows of doped structures are unaligned with the plurality of doped structures of another row of the plurality of rows of doped structures that is adjacent to the respective row.

Some embodiments of the present disclosure provide a method for producing a solar cell, including: providing a substrate including a front surface and a back surface opposite to each other; forming at least one doped structure on the back surface, where the at least one doped structure has doping ions of a first type; forming a tunneling layer covering at least portions of the back surface and a surface of the at least one doped structure away from the substrate; forming a doped conductive layer over a surface of the tunneling layer away from the substrate, where the doped conductive layer includes doping ions of a second type; and forming front electrodes on the front surface and forming back electrodes on a side of the doped conductive layer away from the substrate, where the back electrodes are in electrical connection with the doped conductive layer. The first type is one of N type and P type, and the second type is the other one of N type and P type.

In some embodiments, forming the at least one doped structure, includes: forming an initial doped structure covering the back surface; performing laser processing on portions of the initial doped structure to form the at least one doped structure from the portions of the initial doped structure and to form doped areas of the substrate; and removing portions of the initial doped structure not subjected to the laser processing to remain the at least one doped structure.

In some embodiments, forming the at least one doped structure, includes: doping on portions of the back surface of the substrate to form an initial doped structure from the back surface; performing laser processing on doped portions of the initial doped structure to form doped areas of the substrate; and etching the initial doped structure to remove portions of the initial doped structure not subjected to the laser processing and remain the at least one doped structure.

In some embodiments, after performing the laser processing, the method further includes: performing heat treatment to increase doping junction depths of the doped areas.

In some embodiments, the heat treatment includes: a first heating operation configured to raise an ambient temperature to a first preset temperature, and a second heating operation configured to raise the first preset temperature to a second preset temperature. A heating rate of the first heating operation is greater than a heating rate of the second heating operation.

The technical solutions provided in the embodiments of the present disclosure have at least the advantages as follows: the substrate, the front electrodes, the tunneling layer, the doped conductive layer, and the back electrodes together form a TOPCON cell. The doped conductive layer is formed over the back surface of the TOPCON cell, and the type of the doping ions in the doped conductive layer is different from the type of the doping ions in the at least one doped structure. A recombination contact is formed by the direct contact between the doped conductive layer and the at least one doped structure, or formed using a dielectric layer. In this way, leakage structures can be formed over the back surface of the solar cell, and the voltages on opposing sides of the solar cell can be reduced by the leakage structures, thereby reducing the heating power of the solar cell and ameliorating the hot-spot effect caused by local poor conductivity of the solar cell.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. The drawings do not constitute a scale limitation unless otherwise specified. In order to illustrate the technical solutions in related technologies or in the embodiments of the present disclosure more clearly, the drawings to be used in the embodiments will be briefly described below. It is obvious that the drawings mentioned in the following illustration are only some embodiments of the present disclosure. For those of ordinary skill in the art, other drawings may also be obtained in accordance with these drawings without any inventive effort.
FIG. 1 is a cross-sectional view of a solar cell according to some embodiments of the present disclosure;
FIG. 2 is a top view of a solar cell according to some embodiments of the present disclosure; and
FIGS. 3 to 5 are schematic diagrams of structures corresponding to operations of a method for producing a solar cell according to some embodiments of the present disclosure.

### DETAILED DESCRIPTION OF THE EMBODIMENTS

As known from the background, at present, some TOPCON cells may experience overheating due to partial obstruction, damage, or inconsistent performance of these TOPCON cells, resulting in their working states being different from those of other solar cells. In severe cases, solar cells may be burned out, leading to failure of the solar cells.

Embodiments of the present disclosure provide a solar cell. The substrate, the front electrodes, the tunneling layer, the doped conductive layer, and the back electrodes of the solar cell together form a TOPCON cell. The doped conductive layer is formed over the back surface of the TOPCON cell, and the type of the doping ions in the doped conductive layer is different from the type of the doping ions in the at least one doped structure. A recombination contact is formed by the direct contact between the doped conductive layer and the at least one doped structure, or formed using a dielectric layer. In this way, leakage structures can be formed over the back surface of the solar cell, and the voltages on opposing sides of the solar cell can be reduced by the leakage structures, thereby reducing the heating power of the solar cell and ameliorating the hot-spot effect caused by local poor conductivity of the solar cell.

In the description of the embodiments of the present disclosure, the technical terms "first", "second", and the like are merely intended to distinguish different objects, and shall not be understood as an indication or implication of relative importance or implicit indication of the number, specific sequence, or dominant-subordinate relationship of the technical features indicated. In the description of the embodiments of the present disclosure, "a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification do not necessarily refer to either the same embodiment or separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, "a plurality of" means two or more (including two). Similarly, "a plurality of groups" means two or more groups (including two groups), and "a plurality of pieces" means two or more pieces (including two pieces).

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the illustration of the embodiments of the present disclosure, unless otherwise specified and limited, technical terms such as "installation", "coupling", "connection", or "fixation" should be broadly understood. For example, "connection" may refer to fixed connections, detachable connections, integrated as a whole, mechanical connections or electrical connections, direct connections or indirect connections through an intermediate medium, or internal connections between two components or an interaction relationship between two components. For those skilled in the art, the specific meanings of the above terms in the embodiments of the present disclosure shall be understood according to the specific situations.

In the drawings corresponding to the embodiments of the present disclosure, for better understanding and ease of description, a thickness and an area of a layer are exaggerated. When a component is described as being on the other component or on a surface of the other component, the component may be "directly" on the surface of the other component or there may be a third component between the two components. In contrast, when one component is described as being at the surface of the other component or the other component is formed at or provided at a surface of one component, there is no third component between the two components. In addition, when a component is described as being "substantially" formed on the other component, it indicates that the component is neither formed on the entire surface (or a front surface) of the other component, nor formed on part of an edge of the entire surface.

In the description of the embodiments of the present disclosure, when a component "includes" another component, other components are not excluded and may further be included unless otherwise stated. In addition, when components such as layers, films, regions, or plates are referred to as being "on/located on" another component, they may be "directly on" another component (i.e. there is no other components between them) or there may be other components present therebetween. Moreover, when a component such as a layer, a film, a region, or a plate is "directly on" another component, or the component such as a layer, a film, a region, or a plate is at a surface of another component, it indicates that there are no other components between them.

The terms used in the description of the embodiments herein are for describing particular embodiments only and not intended to be limiting. As used in the description of the embodiments described and in the appended claims, "component" is also intended to include the plural form unless the context clearly indicates otherwise. Herein, a component includes a layer, a film, a region, a plate, or the like.

Various embodiments of the present disclosure will be described in detail below with reference to the accompanying drawings. However, those of ordinary skill in the art shall understand that in the embodiments of the present disclosure, many technical details are provided to enable readers to better understand the embodiments of the present disclosure. However, even without these technical details and various changes and modifications based on the following embodiments, the claimed technical solutions of the present disclosure can still be implemented.

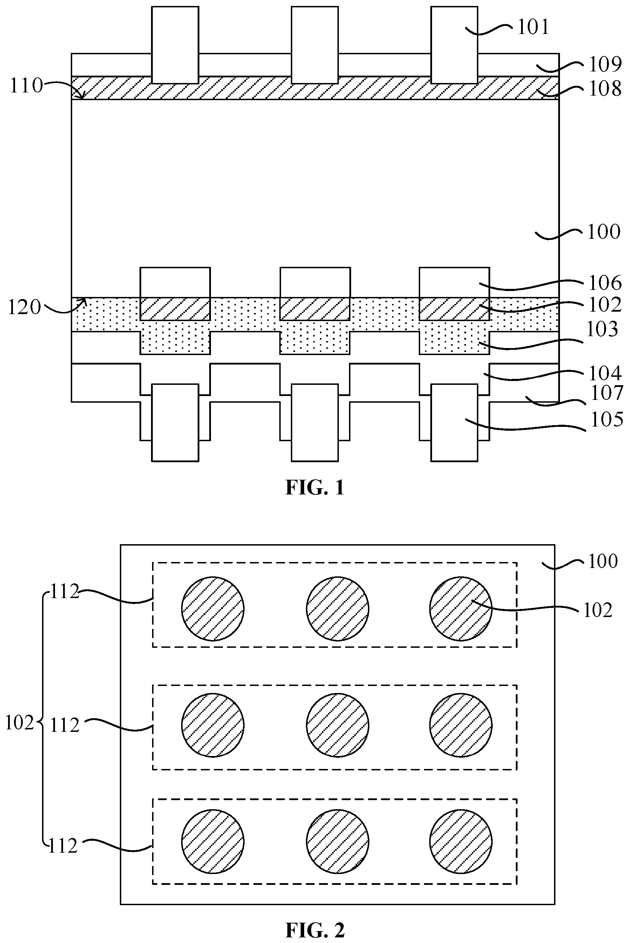

Referring to FIGS. 1 and 2, FIG. 1 is a cross-sectional view of a solar cell according to some embodiments of the present disclosure, and FIG. 2 is a top view showing that a plurality of doped structures are formed on a surface of the substrate.

In some embodiments, the solar cell may include a substrate 100 including a front surface 110 and a back surface 120 opposite to each other.

The solar cell may further include front electrodes 101 formed on the front surface 110.

The solar cell may further include at least one doped structure 102 formed on the back surface 120 and having doping ions of a first type.

The solar cell may further include a tunneling layer 103 covering at least portions of the back surface 120 and a surface of the at least one doped structure 102 away from the substrate 100. The portions of the back surface 120 covered by the tunneling layer 103 are those not covered by the at least one doped structure 102.

The solar cell may further include a doped conductive layer 104 formed over a surface of the tunneling layer 103 away from the substrate 100 and including doping ions of a second type.

The solar cell may further include back electrodes 105 formed on a side of the doped conductive layer 104 away from the substrate 100 and in electrical connection with the doped conductive layer 104. The first type is one of N type and P type, and the second type is the other one of N type and P type.

Some embodiments of the present disclosure provide a solar cell. The substrate 100, the front electrodes 101, the tunneling layer 103, the doped conductive layer 104, and the back electrodes 105 of the solar cell together form a TOPCON cell. The doped conductive layer 104 is formed over the back surface 120 of the TOPCON cell, and the type of the doping ions in the doped conductive layer 104 is different from the type of the doping ions in the at least one doped structure 102. A recombination contact is formed by the direct contact between the doped conductive layer and the at least one doped structure, or formed using a dielectric layer. In this way, leakage structures can be formed over the back surface of the solar cell, and the voltages on opposing sides of the solar cell can be reduced by the leakage structures, thereby reducing the heating power of the solar cell and ameliorating the hot-spot effect caused by local poor conductivity of the solar cell.

The substrate 100 includes a front surface 110 and a back surface 120 opposite to each other. In some embodiments, the solar cell is a single-sided cell, the front surface 110 of the substrate 100 may serve as a light-receiving surface for receiving incident light, and the back surface 120 may serve as a rear surface. In some embodiments, the solar cell is a double-sided cell, and both the front surface 110 and the back surface 120 of the substrate 100 may serve as light-receiving surfaces for receiving incident light. It shall be understood that the rear surface referred to herein can also receive incident light, but the absorption of incident light at the rear surface is less than the absorption of incident light at the light-receiving surface, therefore it is referred to as a rear surface.

In some embodiments, a texturing process may be performed on at least one of the front surface 110 and the back surface 120 of the substrate 100 to form a textured surface on at least one of the front surface 110 and the back surface 120 of the substrate 100. In this way, the absorption and utilization of incident light by the front surface 110 and the back surface 120 of the substrate 100 can be improved. In some embodiments, the textured surfaces may be pyramid-textured surfaces. As a common textured surface, pyramid-textured surfaces can not only reduce the reflectivity of the surfaces of the substrate 100, but also form light traps, thereby improving the absorption effect of incident light by the substrate 100, and improving the photoelectric conversion efficiency of the solar cell.

In some embodiments, the substrate 100 includes doped areas 106. The doped areas 106 are in contact with the at least one doped structure 102 and are substantially aligned with the at least one doped structure 102, respectively. In some embodiments, each doped area of the doped areas 106 is in contact with a respective doped structure of the at least one doped structure 102 and is substantially aligned with the respective doped structure. Herein, "substantially aligned with" indicates that in a thickness direction of the solar cell perpendicular to the front and back surfaces of the substrate, a respective doped structure may be completely aligned with a corresponding doped area, or that a respective doped structure may be slightly offset from a corresponding doped area. On the one hand, the doped areas 106 can also form portions of the leakage structures of the solar cell, thereby further ameliorating the hot-spot effect of the solar cell. On the other hand, providing the doped areas 106 can also facilitate the formation of the leakage structures over the back surface 120 of the solar cell. For the doped structures 102, a doped structure must be formed on the entire back surface 120 of the substrate 100, and then portions of the formed doped structure are removed to form local coverages on the back surface 120. Therefore, by forming the doped areas 106, in the process of removing portions of the formed doped structure, removal of the entire doped structure and the resulted failure of the leakage structures can be prevented, thereby improving the fault tolerance of the process.

In some embodiments, the doped areas 106 have junction depths ranged from 500nm to 2µm, such as 700nm, 900nm, 1.3µm, 1.5µm, 1.8µm, or the like. The larger the junction depths of the doped areas 106, the stronger the leakage effect of the doped areas 106. However, when the junction depths of the doped areas 106 are too large, the light absorption ability of the substrate of the solar cell will be affected, and recombination of a large number of charge carriers will occur at the positions corresponding to the doped areas 106, affecting the photoelectric conversion efficiency of the solar cell. Therefore, the junction depths of the doped areas 106 ranged from 500nm to 2µm can ameliorate the hot-spot effect of the solar cell, and can prevent adverse effect on the efficiency of the solar cell.

In some embodiments, the back surface 120 includes periphery areas and central areas surrounded by the periphery areas, and doped areas 106 formed in the periphery areas have junction depths less than junction depths of doped areas 106 formed in the central areas. The periphery areas of the back surface 120 corresponds to the areas at the edges of the back surface 120, and the central areas of the back surface 120 are the portions located near the center of the back surface 120. Taking a square as an example, the periphery areas refer to the areas in the vicinity of the edges of the square, and the central areas refer to the areas surrounded by the periphery areas. For the periphery areas of the back surface 120, they are close to the edges of the solar cell, and an effect similar to marginal discharge will occur. Therefore, for the periphery areas, the leakage effect in the periphery areas can be weakened by reducing the junction depths of the doped areas located in the periphery areas, so as to make the leakage effect in the periphery areas and the central areas relatively uniform, thereby improving the performance of the solar cell.

In some embodiments, an orthographic projection of the at least one doped structure 102 on the back surface 120 has a shape of circle or polygon. The polygon may be a regular shape such as a rectangle, a square, or the like. For the at least one doped structure 102, the orthographic projection on the back surface 120 having a shape of circle or polygon can reduce the difficulty of forming at least one doped structure 102. Especially in a case where the orthographic projection of the at least one doped structure 102 on the back surface 120 has a shape of circle, circular doped structures 102 have leakage efficiency higher than polygonal doped structures 102. Alternatively, under the same leakage effect, the recombination between circular doped structures 102 and the doped conductive layer 104 is less than the polygonal doped structures.

In some embodiments, the at least one doped structure 102 has a thickness ranged from 0.01µm to 1µm, such as 0.05µm, 0.2µm, 0.5µm, 0.8µm, 0.95µm, or the like. The thicker the doped structures 102, the better the leakage effect of the doped structures 102. However, the thicker the doped structures 102, the more recombination occurs between the doped structures 102 and the doped conductive layer 104. Therefore, the thickness of the at least one doped structure 102 ranged from 0.01µm to 1µm can improve the leakage effect of the at least one doped structure 102, and can prevent adverse effect on the efficiency of the solar cell.

In some embodiments, the at least one doped structure 102 has a size ranged from 1µm to 100µm. The size may refer to the diameter of a circle, the side length of a square, the length of a long side of a rectangle, or the maximum distance between any two points on the edge(s) of the orthographic projection of the at least one doped structure 102 on the back surface 120. The size of the at least one doped structure 102 ranged from 1µm to 100µm can also improve the leakage effect of the at least one doped structure 102, and can prevent adverse effect on the efficiency of the solar cell.

It can be understood that the larger the size of the at least one doped structure 102, the better the leakage effect resulted by the at least one doped structure 102. However, the larger the size of the at least one doped structure 102, the more charge carriers will recombine at the positions corresponding to the at least one doped structure 102, which will affect the collection and transport of the charge carriers in the solar cell.

In some embodiments, a ratio of an area of an orthographic projection of the at least one doped structure 102 on the back surface 120 to an area of the back surface 120 is in a range of 0.00001% to 0.01%. Similarly, the larger the ratio of the area of the orthographic projection of the at least one doped structure 102 on the back surface 120 to the area of the back surface 120, the better the leakage effect resulted by the at least one doped structure 102, and the smaller the ratio of the area of the orthographic projection of the at least one doped structure 102 on the back surface 120 to the area of the back surface 120, the lower the ability of the at least one doped structure 102 to affect the efficiency of the solar cell. Thus, by designing the ratio of the area of the orthographic projection of the at least one doped structure 102 on the back surface 120 to the area of the back surface 120 to be in the range of 0.00001% to 0.01%, the leakage effect of the at least one doped structure 102 can be improved, and adverse effect on the photoelectric conversion efficiency of the solar cell can be prevented.

In some embodiments, the solar cell includes a plurality of doped structures 102 in an array arrangement. In this way, the plurality of doped structures 102 can be uniformly arranged on the back surface 120 of the solar cell, so that the formed leakage structures spread over the solar cell, thereby ameliorating the hot-spot effect on the solar cell.

In some embodiments, the solar cell includes a plurality of rows 112 of doped structures 102, and each row of the plurality of rows 112 of doped structures includes a respective plurality of doped structures 102. In an arrangement direction of the plurality of rows 112 of doped structures 102, the plurality of doped structures 102 of a respective row 112 of the plurality of rows 112 of doped structures 102 are unaligned with the plurality of doped structures 102 of another row 112 of the plurality of rows 112 of doped structures 102 that is adjacent to the respective row. In this way, the uniformity of the arrangement of the leakage structures on the back surface 120 of the solar cell can be further improved, thereby further improving the degree of ameliorating the hot-spot effect by the doped structures 102.

It can be understood that the ability of a doped structure 102 to ameliorate the hot-spot effect is within a certain range. Taking the doped structures 102 having a shape of circle as an example, the leakage of the doped structures 102 can ameliorate the hot-spot effect in a certain area. When the hot-spot effect is occurred at a certain distance from the doped structure 102, the doped structure 102 cannot ameliorate it. Therefore, the plurality of doped structures 102 of a respective row 112 of the plurality of rows 112 of doped structures 102 are designed to be unaligned with the plurality of doped structures 102 of another row 112 of the plurality of rows 112 of doped structures 102 that is adjacent to the respective row, thereby increasing the ameliorating range of the doped structures 102, and further improving the reliability of the solar cell.

In some embodiments, the at least one doped structure 102 includes: a silicon substrate layer having the doping ions of the first type; and a silicon compound having the doping ions of the first type, or a silicon oxide having the doping ions of the first type. That is to say, a doped structure 102 may be formed by converting a portion of the substrate 100 into the doped structure 102, or by forming an additional layer of doped structure 102 on the surface of the substrate 100. Various materials and formation methods may be selected according to various process requirements.

In some embodiments, the doped conductive layer 104 covers at least a portion of sidewalls of the at least one doped structure 102. That is to say, the doped conductive layer 104 may be in direct contact with the at least one doped structure 102, and leakage structures may be formed by the direct contact. In this way, the leakage ability of the at least one doped structure 102 can be further improved, and the hot-spot effect of the solar cell can be further ameliorated.

In some embodiments, the tunneling layer 103 covers a surface of the at least one doped structure 102 away from the substrate, and the doped conductive layer 104 covers a surface of the tunneling layer 103 away from the substrate. The at least one doped structure 102 and the doped conductive layer 104 are spaced apart by the tunneling layer 103. In this way, the at least one doped structure 102 can be prevented from excessively affecting the photoelectric conversion efficiency of the solar cell, and adverse effect on the performance of the solar cell can be prevented.

The doped conductive layer 104 and the tunneling layer 103 form the passivation contact structure of the solar cell. The passivation contact structure provides good surface passivation for the back surface 120 of the substrate 100. The tunneling layer 103 can allow majority charge carriers to tunnel into the doped conductive layer 104 and can prevent minority charge carriers from recombining, such that majority charge carriers can transport transversely in the doped conductive layer 104 and can be collected by metal electrodes, thereby greatly reducing the metal-contact recombination current, and increasing the open-circuit voltage and short-circuit current of the solar cell.

In some embodiments, the solar cell further includes a first passivation layer 107 covering the surface of the doped conductive layer 104 away from the substrate 100. The first passivation layer 107 can provide a good passivation effect on the back surface 120 of the substrate 100, for example, it can perform good chemical passivation on the dangling bonds at the back surface 120, saturate the dangling bonds at the back surface 120, reduce the defect density on the back surface 120, and suppress recombination of charge carriers at the back surface 120.

In some embodiments, the solar cell further includes a front doped layer 108 covering the front surface 110 of the substrate 100 and a second passivation layer 109 covering a surface of the front doped layer 108 away from the substrate 100. The front electrodes 101 are in contact with and electrically connected to the front doped layer 108.

In some embodiments, the concentration of doping ions in the front doped layer 108 and in the at least one doped structure 102 is the same, so that the front doped layer 108 and the at least one doped structure 102 can be formed in a same process operation.

Some embodiments of the present disclosure provide a solar cell. The substrate 100, the front electrodes 101, the tunneling layer 103, the doped conductive layer 104, and the back electrodes 105 of the solar cell together form a TOPCON cell. The doped conductive layer 104 is formed over the back surface 120 of the TOPCON cell, and the type of the doping ions in the doped conductive layer 104 is different from the type of the doping ions in the at least one doped structure 102. A recombination contact is formed by the direct contact between the doped conductive layer and the at least one doped structure, or formed using a dielectric layer. In this way, leakage structures can be formed over the back surface of the solar cell, and the voltages on opposing sides of the solar cell can be reduced by the leakage structures, thereby reducing the heating power of the solar cell and ameliorating the hot-spot effect caused by local poor conductivity of the solar cell.

Some embodiments of the present disclosure provide a method for producing a solar cell. The method may be used to form the solar cell as illustrated in some or all of the above embodiments. The method for producing a solar cell will be illustrated below in conjunction with the accompanying drawings. It is noted that reference may be made to the corresponding illustration in the aforementioned embodiments for the parts same as or corresponding to those in the aforementioned embodiments, which will not be repeated below.

Referring to FIGS. 3 to 5 and FIG. 1, FIGS. 3 to 5 are schematic diagrams of structures corresponding to operations of the method for producing a solar cell according to some embodiments of the present disclosure.

In some embodiments, the method for producing a solar cell may include: providing a substrate 100 including a front surface 110 and a back surface 120 opposite to each other.

The method for producing a solar cell may further include: forming at least one doped structure 102 on the back surface 120, where the at least one doped structure 102 has doping ions of a first type.

The method for producing a solar cell may further include: forming a tunneling layer 103 covering at least portions of the back surface 120 and a surface of the at least one doped structure 102 away from the substrate 100. The portions of the back surface 120 covered by the tunneling layer 103 are those not covered by the at least one doped structure 102.

The method for producing a solar cell may further include: forming a doped conductive layer 104 over a surface of the tunneling layer 103 away from the substrate 100, where the doped conductive layer 104 includes doping ions of a second type.

The method for producing a solar cell may further include: forming front electrodes 101 on the front surface 110 and forming back electrodes 105 on a side of the doped conductive layer 104 away from the substrate 100, where the back electrodes 105 are in electrical connection with the doped conductive layer 104. The first type is one of N type and P type, and the second type is the other one of N type and P type.

In the process of forming a TOPCON cell, the at least one doped structure 102 is formed on the back surface 120, and at least one leakage channel is formed by the at least one doped structure 102 and the doped conductive layer 104. The at least one leakage channel can ameliorate the hot-spot effect on the solar cell, thereby preventing damage and resulted failure of the solar cell caused by the hot-spot effect, and improving the reliability of the solar cell.

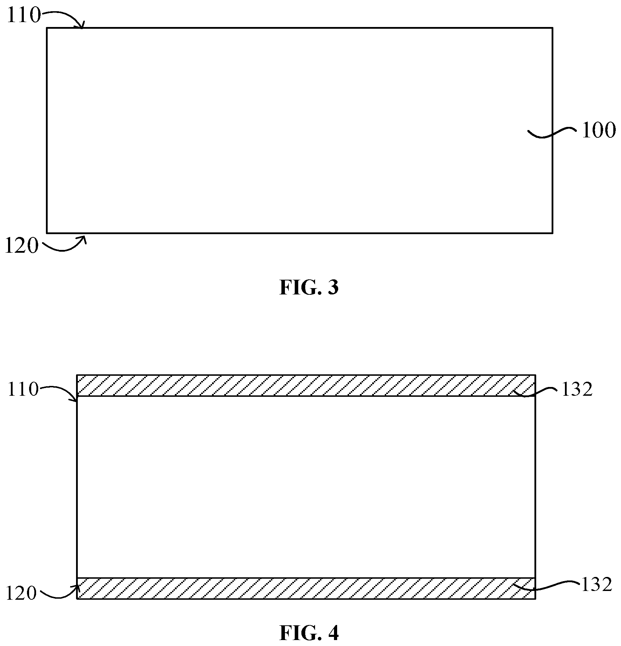

Referring to FIG. 3, FIG. 3 shows a morphology of a substrate provided in some embodiments of the present disclosure.

In some embodiments, after providing the substrate 100, the surfaces of the substrate 100 may be textured to form pyramid structures on the front surface 110 and/or back surface 120 of the substrate 100, thereby improving the light absorption capacity of the substrate 100.

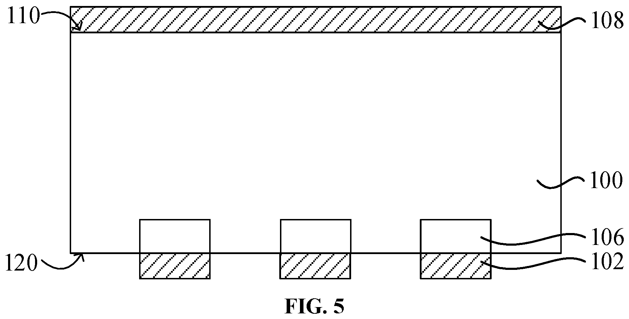

Referring to FIGS. 4 and 5, FIG. 4 shows that an initial doped structure is formed on the basis of FIG. 3, and FIG. 5 shows that doped structures are formed on the basis of FIG. 4.

In some embodiments, forming the at least one doped structure 102, includes: forming an initial doped structure 132 covering the back surface 120; performing laser processing on portions of the initial doped structure 132 to form the at least one doped structure 102 from the portions of the initial doped structure and to form doped areas 106 of the substrate 100; and removing portions of the initial doped structure 132 not subjected to the laser processing to remain the at least one doped structure 102.

The initial doped structure 132 is formed by deposition on the entire surface, then the laser processing is performed. The etching selectivity ratio of the portions subjected to the laser processing to the portions not subjected to the laser processing will change, and the portions of the initial doped structure 132 not subjected to the laser processing may be removed utilizing the different etching selectivity ratios, thereby forming the doped structures 102. Compared to directly forming the doped structures 102 at local areas of the back surface 120, removing portions of the initial doped structure 132 after forming the initial doped structure 132 is beneficial for reducing process difficulty and facilitates control of the positions of the doped structure 102, so that the positions of the doped structures 102 can be adjusted according to needs. Moreover, by forming the doped areas 106 in the substrate 100, the initial doped structure 132 can be prevented from being completely removed during the etching process, thereby preventing the resulted failure of leakage channels.

In some embodiments, forming the at least one doped structure 102, includes: doping on portions of the back surface 120 of the substrate 100 to form an initial doped structure 132 from the back surface 120; performing laser processing on doped portions of the initial doped structure 132 to form doped areas 106 of the substrate 100; and etching the initial doped structure 132 to remove portions of the initial doped structure 132 not subjected to the laser processing and remain the at least one doped structure 102. In other words, portions of the back surface 120 are doped to form the initial doped structure 132, then the laser processing is performed on doped portions of the initial doped structure 132 to increase the junction depths of the doped portions, and then the portions of the initial doped structure 132 not subjected to the laser processing are removed using etching to form the at least one doped structure 102.

By forming the at least one doped structure 102 using portions of the substrate 100, the process difficulty of producing the solar cell also can be reduced. Moreover, increasing the junction depths of portions of the initial doped structure 132 using laser processing can also facilitate the control of the positions of the doped structures 102.

It can be understood that by increasing junction depths of portions of the initial doped structure 132 using laser processing, etching can be performed on the entire initial doped structure 132 or back surface 120. Due to the fact that the portions subjected to the laser processing have larger junction depths, after removing the portions of the initial doped structure 132 not subjected to the laser processing, at least some of each portion subjected to the laser processing can be remained to form the doped structures 102.

In some embodiments, the initial doped structures 132 may be formed on both the front surface 110 and the back surface 120 of the substrate 100 using diffusion, and then the laser processing is performed only on the back surface 120.

In some embodiments, after performing the laser processing, the method further includes: performing heat treatment to increase doping junction depths of the doped areas 106. By increasing the junction depths of the doped areas 106, on the one hand, the leakage effect of the doped structures 102 can be further improved, and on the other hand, the fault tolerance of producing the solar cell can also be improved, thereby preventing removing the doped structures 102 to be retained when removing portions of the initial doped structure 132, thus improving the stability of the process.

In some embodiments, the heat treatment includes: a first heating operation configured to raise an ambient temperature to a first preset temperature, and a second heating operation configured to raise the first preset temperature to a second preset temperature. A heating rate of the first heating operation is greater than a heating rate of the second heating operation.

The first heating operation may be a preheating operation configured to rapidly raises the ambient temperature of the solar cell to the first preset temperature. The second heating operation may be configured to control the increase of the doping junction depths of the doped areas 106 and to raise the temperature to an optimal temperature. The first heating operation is used for preset purposes, so the heating rate of the first heating operation may be controlled to be higher, thereby reducing the process duration of the producing method. For the second heating operation, raising temperature and diffusion occur concurrently during the second heating operation. Thus, it is necessary to control the heating rate of the second heating operation, so as to provide time for the diffusion of ions, thereby achieving the diffusion during raising temperature, and reducing the duration of the second heating operation for the solar cell.

In some embodiments, the first preset temperature is in a range of 800°C to 900°C, such as 810°C, 820°C, 840°C, 860°C, 880°C, 890°C, or the like, and the second preset temperature is in a range of 1000°C~1200°C, such as 1050°C, 1080°C, 1100°C, 1130°C, 1160°C, 1180°C, or the like. With the first heating operation, the process temperature of the solar cell can quickly raise to 800°C~900°C, facilitating the temperature to raise to a temperature for subsequent heating treatment. With the second heating operation, the process temperature of the solar cell can raise to 1000°C~1200°C. This temperature can facilitate the diffusion of charge carriers in the solar cell, thereby improving the diffusion rate of charge carriers and preventing excessively fast diffusion.

In some embodiments, the heating rate of the first heating operation is in a range of 10°C/min to 15°C/min, such as 11°C/min, 12°C/min, 13°C/min, 14°C/min, or the like, and the heating rate of the second heating operation is in a range of 3°C/min to 7°C/min, such as 4°C/min, 5°C/min, 6°C/min, or the like. By setting the heating rate of the first heating operation in the range of 10°C/min to 15°C/min, the time taken for the temperature of the heat treatment to raise to the first preset temperature can be reduced, and rapid temperature changes in the environment where the solar cell is located can be prevented, thereby reducing the possibility of anomaly of the solar cell. By setting the heating rate of the second heating operation in the range of 3°C/min to 7°C/min, the diffusion of charge carriers in the solar cell can be implemented in a gradually heating environment, thereby preventing the uneven diffusion of charge carriers caused by the rapidly raised ambient temperature of the solar cell during diffusion of charge carriers.

In some embodiments, the process duration of the heat treatment ranges from 2000 seconds to 10000 seconds. The longer the process duration of the heat treatment, the larger the doping junction depths of the doped areas 106 will be, and the leakage performance will be better. However, excessive doping junction depths will lead to a decrease in the photoelectric conversion efficiency of the formed solar cell. Therefore, by designing the process duration of the heat treatment to be in a range of 2000 seconds to 10000 seconds, the leakage performance of the initial doped structure 132 can be improved, and adverse effect on the photoelectric conversion efficiency of the solar cell can be prevented.

In some embodiments, the process duration of the heat treatment is in a range of 3000 seconds to 7000 seconds. With this process duration, the leakage performance of the initial doped structure 132 and the adverse effect on the photoelectric conversion efficiency of the solar cell are both controlled within a reasonable range.

In some embodiments, the laser processing has the following process parameters: a type of laser is purple light, green light, or red light; a frequency of the laser is in a range of 100KHz to 1000KHz; a diameter of a laser spot is in a range of 1µm to 100µm; and energy of the laser is in a range of 1W to 500W. With these process parameters, the doping junction depths of the doped areas 106 can be increased and excessive damage to the doped structures 102 caused by the laser processing can be prevented, thereby improving the reliability of the formed solar cell.

In some embodiments, removing portions of the initial doped structure 132 not subjected to the laser processing, includes: a first etching treatment configured to etch the initial doped structure 132 using hydrofluoric acid with a mass fraction of 30% to 70%; an alkali polishing treatment configured to clean the initial doped structure 132 using an alkaline solution; and a second etching treatment configured to etch the initial doped structure 132 using hydrofluoric acid with a mass fraction of 0.5% to 5%.

The first etching treatment is used for large-area cleaning of the initial doped structure 132, thereby removing the portions of the initial doped structure 132 not subjected to the laser processing. The alkali polishing treatment is used to clean the residual etching reagents from the first etching treatment, and to form a textured surface on the surface of the substrate 100 exposed after etching the initial doped structure 132. The second etching treatment is used to clean the residual reagents from the alkali polishing treatment.

In some embodiments, the reagent for the alkali polishing treatment may include potassium hydroxide, hydrogen peroxide, alkali polishing additives, and deionized water.

In some embodiments, after the first etching treatment, the method may further include: performing a first wet bench cleaning, a wet bench pre-cleaning, and a second wet bench cleaning, then the alkali polishing treatment is performed. After the alkali polishing treatment, the method may further include: performing a third wet bench cleaning, a wet bench post-cleaning, and a water rinsing, then the second etching treatment is performed. After the second etching treatment, a fourth wet bench cleaning may be performed, and then drying is performed to complete the removal of the initial doped structure 132.

It can be understood that the wet bench cleaning, wet bench pre-cleaning, wet bench post-cleaning, and water rinsing are all aimed at removing the substances generated by the reaction and removing the charge carriers remaining on the surface of the substrate 100, thereby improving the reliability of the formed solar cell.

Referring to FIG. 1, FIG. 1 shows the formation of the tunneling layer, the doped conductive layer, the first passivation layer, and the second passivation layer on the basis of FIG. 5.

In some embodiments, the tunneling layer 103 and the doped conductive layer 104 may be formed in a back-to-back manner. It is noted that the back-to-back manner refers to that the surfaces of two solar cells are abutted against each other. Taking the formation of the tunneling layer 103 as an example, the front surfaces 110 of the two solar cells are abutted against each other, thus the back surfaces 120 of the two solar cells face outward. In this case, the tunneling layer 103 is formed on the exposed surfaces of these two solar cells. It can be understood that since the front surfaces 110 of these two solar cells are not exposed, no tunneling layer 103 is formed on the front surfaces 110 of the solar cells.

After forming the tunneling layer 103 and the doped conductive layer 104, the overcoating layers on the front surface 110 and on the sidewalls may be removed by etching. It can be understood that when forming the doped conductive layer 104, overcoating layers will inevitably be formed on the front surface 110 and on the sidewalls of the substrate 100. In this case, the overcoating layer on the front surface 110 and on the sidewalls can be removed by etching to prevent adverse effect on the performance of the solar cell.

It can be understood that in the process of forming the initial doped layer, since the initial doped layer is also formed on the front surface 110, this initial doped layer formed on the front surface 110 may serve as the front doped layer 108.

In some embodiments, the method further includes forming a first passivation layer 107 on the front surface 110 and a second passivation layer 109 on the back surface 120. After forming the first passivation layer 107 on the front surface 110 and the second passivation layer 109 on the back surface 120, the front electrodes 101 and the back electrodes 105 are formed.

Those skilled in the art shall understand that the above-mentioned embodiments are specific examples for implementing the present disclosure. In practice, various changes may be made in form and details without departing from the scope of the present disclosure. Therefore, the patent scope of protection of the present disclosure shall be subject to the scope limited by the appended claims.

## Claims

1. A solar cell, comprising:
a substrate (100) including a front surface (110) and a back surface (120) opposite to each other;
front electrodes (101) formed on the front surface (110);
at least one doped structure (102) formed on the back surface (120) and having doping ions of a first type;
a tunneling layer (103) covering at least portions of the back surface (120) and a surface of the at least one doped structure (102) away from the substrate (100);
a doped conductive layer (104) formed over a surface of the tunneling layer (103) away from the substrate (100), the doped conductive layer including doping ions of a second type; and
back electrodes (105) formed on a side of the doped conductive layer (104) away from the substrate (100) and in electrical connection with the doped conductive layer (104);
wherein the first type is one of N type and P type, and the second type is the other one of N type and P type.

2. The solar cell according to claim 1, wherein the substrate (100) includes doped areas (106), and the doped areas (106) are in contact with the at least one doped structure (102) and are substantially aligned with the at least one doped structure (102), respectively.

3. The solar cell according to claim 2, wherein the back surface (120) includes periphery areas and central areas surrounded by the periphery areas, and doped areas (106) formed in the periphery areas have junction depths less than junction depths of doped areas (106) formed in the central areas.

4. The solar cell according to any one of claims 1 to 3, wherein the doped conductive layer (104) covers at least a portion of sidewalls of the at least one doped structure (102).

5. The solar cell according to any one of claims 1 to 4, wherein an orthographic projection of the at least one doped structure (102) on the back surface (120) has a shape of circle or polygon.

6. The solar cell according to any one of claims 1 to 5, wherein the at least one doped structure (102) has a thickness ranged from 0.01µm to 1µm.

7. The solar cell according to any one of claims 1 to 6, wherein a ratio of an area of an orthographic projection of the at least one doped structure (102) on the back surface (120) to an area of the back surface (120) is in a range of 0.00001% to 0.01%.

8. The solar cell according to any one of claims 1 to 7, including a plurality of rows (112) of doped structures (102), wherein each row of the plurality of rows (112) of doped structures (102) includes a respective plurality of doped structures (102), and in an arrangement direction of the plurality of rows (112) of doped structures (102), the plurality of doped structures (102) of a respective row of the plurality of rows (112) of doped structures (102) are unaligned with the plurality of doped structures (102) of another row of the plurality of rows (112) of doped structures (102) that is adjacent to the respective row.

9. The solar cell according to any one of claims 1 to 8, wherein the at least one doped structure (102) includes:
a silicon substrate layer having the doping ions of the first type; and
a silicon compound having the doping ions of the first type, or a silicon oxide having the doping ions of the first type.

10. A method for producing a solar cell, comprising:
providing a substrate (100) including a front surface (110) and a back surface (120) opposite to each other;
forming at least one doped structure (102) on the back surface (120), wherein the at least one doped structure (102) has doping ions of a first type;
forming a tunneling layer (103) covering at least portions of the back surface (120) and a surface of the at least one doped structure (102) away from the substrate (100);
forming a doped conductive layer (104) over a surface of the tunneling layer (103) away from the substrate (100), wherein the doped conductive layer (104) includes doping ions of a second type; and
forming front electrodes (101) on the front surface (110) and forming back electrodes (105) on a side of the doped conductive layer (104) away from the substrate (100), wherein the back electrodes (105) are in electrical connection with the doped conductive layer (104);
wherein the first type is one of N type and P type, and the second type is the other one of N type and P type.

11. The method according to claim 10, wherein forming the at least one doped structure (102), includes:
forming an initial doped structure covering the back surface (120);
performing laser processing on portions of the initial doped structure to form the at least one doped structure (102) from the portions of the initial doped structure and to form doped areas (106) of the substrate (100); and
removing portions of the initial doped structure not subjected to the laser processing to remain the at least one doped structure (102).

12. The method according to claim 10, wherein forming the at least one doped structure (102), includes:
doping on portions of the back surface (120) of the substrate (100) to form an initial doped structure from the back surface (120);
performing laser processing on doped portions of the initial doped structure to form doped areas (106) of the substrate (100); and
etching the initial doped structure to remove portions of the initial doped structure not subjected to the laser processing and remain the at least one doped structure (102).

13. The method according to claim 11 or claim 12, after performing the laser processing, further including:
performing heat treatment to increase doping junction depths of the doped areas (106);
wherein the heat treatment includes:
a first heating operation configured to raise an ambient temperature to a first preset temperature; and
a second heating operation configured to raise the first preset temperature to a second preset temperature;
wherein a heating rate of the first heating operation is greater than a heating rate of the second heating operation.

14. The method according to claim 13, wherein the first preset temperature is in a range of 800°C to 900°C, and the second preset temperature is in a range of 1000°C to 1200°C; and
wherein the heating rate of the first heating operation is in a range of 10°C/min to 15°C/min, and the heating rate of the second heating operation is in a range of 3°C/min to 7°C/min.

15. The method according to claim 11 or claim 12, wherein removing portions of the initial doped structure not subjected to the laser processing, includes:
a first etching treatment configured to etch the initial doped structure using hydrofluoric acid with a mass fraction of 30% to 70%;
an alkali polishing treatment configured to clean the initial doped structure using an alkaline solution; and
a second etching treatment configured to etch the initial doped structure using hydrofluoric acid with a mass fraction of 0.5% to 5%.
